# EUROPEAN PATENT APPLICATION

(11) **EP 4 818 762 A1**
(43) Date of publication of application: **07.10.2026**
(21) Application number: 25190646.7
(22) Date of filing: 21.07.2025
(51) Int. Cl.: G01V 3/10, G01V 3/12, G01R 19/15, G01V 3/15

(54) **WALL DETECTION INSTRUMENT**

(30) Priority: 02.04.2025 CN 202520629732 U
(71) Applicant: Yongzhou Noyafa Electronic Co., Ltd., Yongzhou, Hunan (CN)
(72) Inventor: Lei, Ming, Yongzhou, Hunan (CN); Wu, Haiyan, Yongzhou, Hunan (CN); Zhang, Jianping, Yongzhou, Hunan (CN)
(74) Representative: Petraz, Gilberto Luigi

(57) **Abstract**

The present application provides a wall detection instrument, the wall detection instrument including: a housing, the housing being provided with a marking hole, the marking hole penetrating through opposite two sides of the housing; a distance measurement module, the distance measurement module being installed in the housing, the distance measurement module being configured to measure a distance from a target position to the wall detection instrument; and a detection module, the detection module being mounted in the housing and adjacent to the marking hole, the detection module being configured to detect a hidden object in a solid medium.

## Description

### TECHNICAL FIELD

The present application relates to the technical field of measurement, specifically relating to a wall detection instrument.

### BACKGROUND

A wall detection instrument is an electronic instrument capable of positioning and detecting various metal and non-metal objects within a wall. Existing wall detection instruments have singular functionality, and it is not convenient to make a precise mark on the wall due to obstruction by the wall detection instrument when detecting an object within a wall (for example, metal).

### SUMMARY

The present application provides a wall detection instrument that incorporates both distance measurement functionality and solid medium detection functionality, and during detection of a solid medium, a user may conveniently and relatively accurately mark the solid medium by utilizing the marking hole.

The wall detection instrument includes:
a housing, the housing being provided with a marking hole, the marking hole penetrating through opposite two sides of the housing;
a distance measurement module, the distance measurement module being installed in the housing, the distance measurement module being configured to measure a distance from a target position to the wall detection instrument; and
a detection module, the detection module being mounted in the housing and adjacent to the marking hole, the detection module being configured to detect a hidden object in a solid medium.

In some implementations, the housing is provided with a first end portion and a second end portion, the first end portion and the second end portion are opposite two ends in a length direction of the housing, the distance measurement module is disposed at the first end portion, and the detection module is disposed at the second end portion.

In some implementations, the housing is provided with a first end portion and a second end portion, the first end portion and the second end portion are opposite two ends in a length direction of the housing, the wall detection instrument further includes a non-contact voltage, NCV, module, and the NCV module is disposed at the second end portion.

In some implementations, the housing is provided with a first side and a second side that are opposite to each other, the marking hole is extended from the first side through to the second side, the detection module includes a first button, and the first button is exposed on the first side; and the wall detection instrument further includes a display module, wherein the display module is disposed between the detection module and the distance measurement module, and a display area of the display module is visible from the first side.

In some implementations, an amount of the first buttons is plural, and at least two of the first buttons are arranged around the marking hole.

In some implementations, the distance measurement module includes a second button, and the second button is exposed on the first side.

In some implementations, the detection module further includes a detection coil disposed in the housing, the detection coil is arranged around the marking hole, and the detection coil is configured to acquire information of the hidden object.

In some implementations, a cross section of the marking hole is circular.

In some implementations, the wall detection instrument further includes a marking module disposed in the housing, the housing is provided with a light exit port, and the marking module is configured to emit a laser line through the light exit port to outside of the housing, so that a preset mark appears at an irradiated position.

In some implementations, the housing includes a first housing, a second housing, and a columnar structure, the first housing and the second housing together form an accommodation space, the accommodation space is configured to accommodate the distance measurement module and the detection module, opposite two ends of the columnar structure are respectively connected to the first housing and the second housing, the columnar structure is provided with a through hole, and the through hole constitutes the marking hole.

The present application provides a wall detection instrument, and the wall detection instrument incorporates both a distance measurement functionality and a solid medium detection functionality due to simultaneous integration of a distance measurement module capable of measuring distance and a detection module capable of detecting a solid medium. Additionally, the marking hole may be oriented toward user themselves when a user uses the detection module to detect a solid medium since the housing is provided with a marking hole; a marker pen may be passed through the marking hole to make a mark on the solid medium when a hidden object is detected in the solid medium; therefore, the provision of the marking hole facilitates the user in making marks; and at the same time, marks made by passing through the marking hole are relatively accurate since the detection module is arranged adjacent to the marking hole.

### BRIEF DESCRIPTION OF THE DRAWINGS

FIG. 1 is a front view of the wall detection instrument according to an embodiment of the present application;
FIG. 2 is a cross-sectional view of the wall detection instrument according to an embodiment of the present application;
FIG. 3 is a perspective view of the wall detection instrument according to an embodiment of the present application;
FIG. 4 is a diagram of a relative positional relationship between the marking hole and a detection coil according to an embodiment of the present application.

Reference sign description:
wall detection instrument-1; housing-10; first housing-110; second housing-120; columnar structure-130; first hollow column-131; second hollow column-132; distance measurement module-20; second button-210; signal transceiver component-220; detection module-30; first button-310; detection coil-320; display module-40; NCV module-50; marking module-60; first side-C1; second side-C2; third side-C3; first end portion-D1; second end portion-D2; marking hole-X; light exit port-Y.

### DETAILED DESCRIPTION

Existing wall detection instruments only possess wall detection functionality; for other functions, it is necessary to purchase additional instruments separately, for example, a distance measuring instrument with distance measurement functionality. It is to be understood that it leads to frequent instrument changes when users need to detect or measure different objects and parameters since each instrument may only perform one function, resulting in significant inconvenience and complexity. Additionally, an orthographic projection position of the detection module of the wall detection instrument on the wall corresponds to the hidden object when using a wall detection instrument to detect a hidden object within a wall (for example, metal). The user wishes to mark this projection position to indicate the location of the hidden object. However, the user must first move the wall detection instrument away before making the mark since the wall detection instrument will obstruct the projection position during detection. However, the actual marking position may deviate from the projection position, meaning it is unable to conveniently make precise marks.

Based on the above, the present application aims to provide a solution capable of resolving but not limited to the aforementioned technical problems, with detailed content to be elaborated in subsequent embodiments.

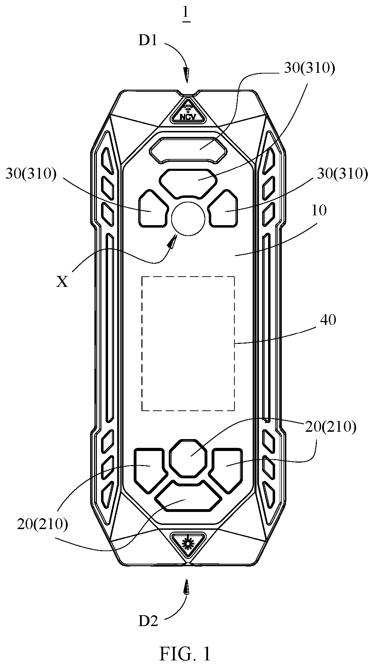

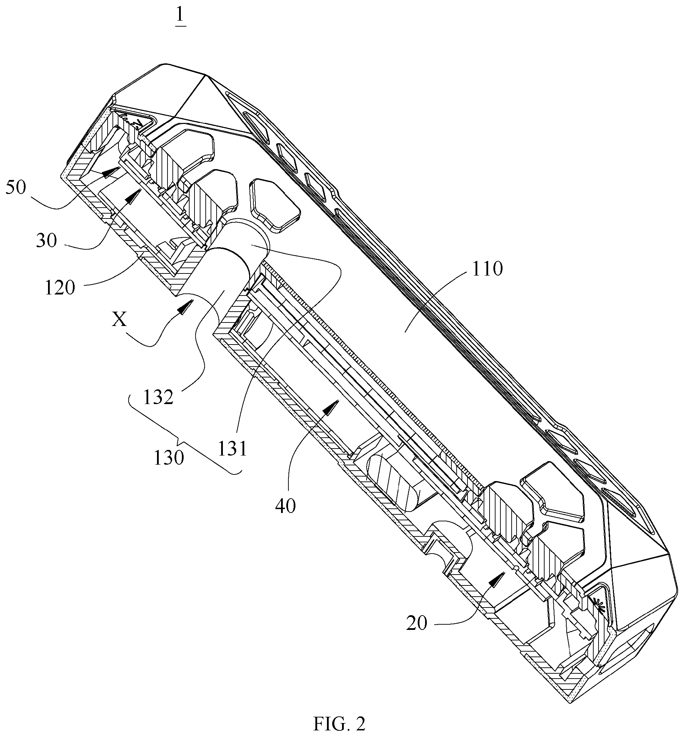

Referring to FIGS. 1 and 2, the present application provides a wall detection instrument 1, the wall detection instrument 1 may be applied to but is not limited to scenarios such as home decoration, building construction, security inspection, and archaeological research. In some embodiments, the wall detection instrument 1 may also be referred to as a measuring instrument or detection instrument. The wall detection instrument 1 provided by the present application includes: a housing 10, a distance measurement module 20, and a detection module 30, which are specifically introduced below with reference to the accompanying drawings.

The housing 10 may also be referred to as an outer shell. The housing 10 may be made of one or more materials such as plastic or rubber, with the material preferably being one that does not interfere or minimally interferes with the measurement functions of the distance measurement module 20 and the detection module 30. The housing 10 may be assembled from multiple components, facilitating installation and fixation of the distance measurement module 20 and the detection module 30. The housing 10 is provided with a marking hole X, the marking hole X penetrating through opposite two sides of the housing 10, meaning that the marking hole X is a through hole.

The distance measurement module 20 is mounted in the housing 10 to protect the distance measurement module 20 through the housing 10. The distance measurement module 20 is configured to measure a distance from a target position (such as a wall, ceiling) to the wall detection instrument 1. In the wall detection instrument 1 provided by the present application, the distance measurement principle of the distance measurement module 20 may include but is not limited to laser measurement methods, ultrasonic measurement methods, or infrared measurement methods, which is not limited in the present application.

The detection module 30 is mounted in the housing 10 to protect the detection module 30 through the housing 10. Moreover, the detection module 30 is arranged adjacent to the marking hole X. The detection module 30 is configured to detect hidden objects (such as cavities, metals, non-metals, wood, etc.) in solid media (for example, walls, floors, ceilings, etc.). For example, before drilling into a wall to install equipment, the detection module 30 may be employed to determine the precise location and depth of pipes or structural components within the wall to avoid damage. In the wall detection instrument 1 provided by the present application, the detection principle of the detection module 30 may include but is not limited to electromagnetic radar methods or electromagnetic induction methods, which is not limited in the present application.

In summary, the wall detection instrument 1 provided by the present application incorporates both a distance measurement functionality and a solid medium detection functionality due to simultaneous integration of the distance measurement module 20 capable of measuring distance and the detection module 30 capable of detecting a solid medium. Additionally, the marking hole X may be oriented toward users themselves when a user employs the detection module 30 to detect a solid medium since the housing 10 is provided with the marking hole X; a marker pen can be passed through the marking hole X to make a mark on the solid medium when a hidden object is detected within the solid medium. Therefore, the arrangement of the marking hole X facilitates the user in marking, and marks made through the marking hole X are relatively accurate since the detection module 30 is adjacent to the marking hole X.

Referring to FIG. 1, the housing 10 is provided with a first end portion D1 and a second end portion D2, the first end portion D1 and the second end portion D2 are opposite two ends in a length direction of the housing 10, the distance measurement module 20 is disposed at the first end portion D1, and the detection module 30 is disposed at the second end portion D2. That is, the distance measurement module 20 and the detection module 30 are disposed at opposite two ends of the housing 10. It is to be understood that the distance measurement module 20 and the detection module 30 each contain several electronic components, and these electronic components may interfere with each other during operation. In the present embodiment, by disposing the distance measurement module 20 and the detection module 30 at the two ends of the housing 10 respectively, the possibility of mutual interference between the two modules is thus reduced, thereby ensuring that each module may obtain relatively accurate measurement results when operating.

Referring to FIG. 1, the housing 10 is provided with a first end portion D1 and a second end portion D2, the first end portion D1 and the second end portion D2 being opposite two ends in a length direction of the housing 10. Referring to FIG. 2, the wall detection instrument 1 further includes an NCV module 50, the NCV module 50 being disposed at the second end portion D2. The NCV module 50 is a Non-Contact Voltage detection module that is able to determine the presence of voltage without directly contacting the measured object. For example, the NCV module 50 may be employed to rapidly judge whether an electric wire is live to avoid electric shock risks; or for another example, the NCV module 50 may be employed to locate live wires within a wall (such as socket or switch circuits). During use of the wall detection instrument 1, the NCV module 50 may be employed independently or together with the detection module 30. It is to be understood that it enables both detection of a hidden object within a solid medium and determination of whether the hidden object is live if the NCV module 50 is employed together with the detection module 30, thereby improving detection efficiency without requiring separate operations.

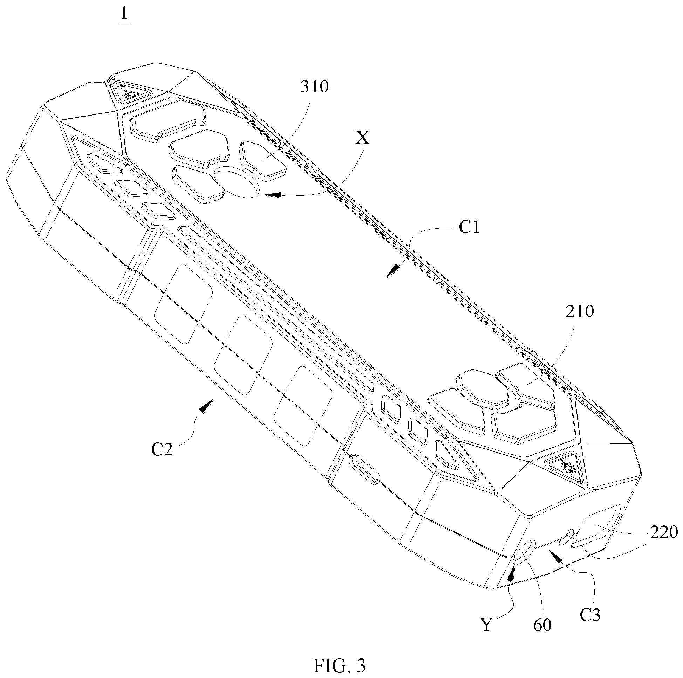

Referring to FIG. 3, the housing 10 is provided with a first side C1 and a second side C2 that are opposite to each other, the marking hole X extending from the first side C1 through to the second side C2, that is, the marking hole X penetrates both the first side C1 and the second side C2 simultaneously. The detection module 30 includes a first button 310, the first button 310 being exposed on the first side C1. The user may control the detection module 30 by pressing or touching the first button 310. The type of the first button 310 may include, but is not limited to, a mechanical button (triggered by physical contact), a capacitive button (triggered by detecting capacitance changes without physical contact), a resistive button (triggered by pressure-induced resistance value changes), or an optical button (triggered by optical signal variations). The amount of the first buttons 310 may be one or plural. For example, the specific amount may be one, two, three, four, five, etc. Each first button 310 corresponds to a different function when the amount of the first buttons 310 is plural. The relevant embodiments of the present application provide exemplary descriptions using plural first buttons 310.

In the present embodiment, the first side C1 of the housing 10 may be oriented toward users themselves when the user employs the detection module 30 to detect a solid medium. Thus, the user may simultaneously view both the first buttons 310 and the marking hole X from the first side C1. This facilitates both marking the solid medium through the marking hole X and operating the first buttons 310 accurately, particularly when plural first buttons 310 are present.

Referring to FIG. 3, an amount of the first buttons 310 is plural, and at least two of the first buttons 310 are arranged around the marking hole X. For example, when the amount of the first buttons 310 is three, the three first buttons 310 surround the marking hole X; for another example, when the amount of the first buttons 310 is four, three of the first buttons 310 surround the marking hole X. In the present embodiment, arranging at least two first buttons 310 around the marking hole X fully utilizes space on the first side C1 of the housing 10 while ensuring user accessibility. This configuration further associates the first buttons 310 with the marking hole X, indicating that the marking hole X should be used in conjunction with the detection module 30 rather than the distance measurement module 20.

Referring to FIG. 3, the distance measurement module 20 includes a second button 210, and the second button 210 is exposed on the first side C1. The user may control the distance measurement module 20 by pressing or touching the second button 210. The type of the second button 210 may include, but is not limited to, a mechanical button (triggered by physical contact), a capacitive button (triggered by detecting capacitance changes without physical contact), a resistive button (triggered by pressure-induced resistance value changes), or an optical button (triggered by optical signal variations). The amount of the second buttons 210 may be one or plural. For example, the specific amount may be one, two, three, four, five, etc. Each second button 210 corresponds to a different function when the amount of the second buttons 210 is plural. The relevant embodiments of the present application provide exemplary descriptions using plural second buttons 210.

In the present embodiment, arranging the first buttons 310 and the second buttons 210 exposed on the same side of the housing 10 enables the user to simultaneously view both the first buttons 310 and the second buttons 210 when using the wall detection instrument 1. The user may consciously avoid unintentionally touching the second buttons 210 when using the detection module 30; the user may consciously avoid unintentionally touching the first buttons 310 when using the distance measurement module 20.

Referring to FIG. 3, the distance measurement module 20 may further include a signal transceiver component 220 configured to acquire distance information from a target position to the wall detection instrument 1. For example, the signal transceiver component 220 is a laser transceiver device that emits a laser signal (referred to as a first signal) toward the target position and receives a laser signal reflected back from the target position (a second signal); a processor can thereby determine the distance from the target position to the wall detection instrument 1 based on the first signal and the second signal. The housing 10 is further provided with a third side C3 located between the first side C1 and the second side C2. The signal transceiver component 220 is disposed inside the housing 10 and exposed on the third side C3 to transmit and receive signals at the third side C3.

Referring to FIG. 3, the wall detection instrument 1 further includes a marking module 60 disposed inside the housing 10. The housing 10 is further provided with a third side C3 located between the first side C1 and the second side C2. The housing 10 is provided with a light exit port Y arranged at the third side C3. The marking module 60 is configured to emit a laser line through the light exit port Y to outside of the housing 10, thereby causing a preset mark to appear at an irradiated position. The preset mark may include but is not limited to a horizontal line, a vertical line, a cross line, a circle, or a point, with no limitation imposed. The marking module 60 assists in measurement positioning, ensuring the wall detection instrument 1 accurately aligns with a target point to improve measurement precision and operational convenience. During use of the wall detection instrument 1, the marking module 60 may operate independently or together with the distance measurement module 20. It is to be understood that using the marking module 60 with the distance measurement module 20 helps the distance measurement module 20 precisely target the measurement position, thereby enhancing distance measurement accuracy.

Referring to FIGS. 1 and 2, the wall detection instrument 1 further includes a display module 40 communicatively connected to the detection module 30 and the distance measurement module 20 either directly or indirectly. The display module 40 may display real-time detection results from the detection module 30 or the distance measurement module 20, or provide an operational interface for user parameter configuration. A display area of the display module 40 is visible from the first side C1, meaning that content displayed by the display module 40 is observable by the user from the first side C1 of the housing 10. The display module 40 is disposed between the detection module 30 and the distance measurement module 20, thereby isolating the detection module 30 and the distance measurement module 20 to reduce mutual interference possibilities while enabling substantially equal distances from the display module 40 to both modules. This facilitates rapid viewing of display content when operating either module.

When using the detection module 30, displayed content of the display module 40 may include but is not limited to material information or positional data of hidden objects within solid media. The display module 40 may be electrically connected directly or indirectly to at least one first button 310 (hereinafter referred to as first control button) in the detection module 30. Displayed content of the display module 40 changes when the first control button is pressed.

Displayed content of the display module 40 may include but is not limited to the distance from a target position to the wall detection instrument 1 When using the distance measurement module 20. The display module 40 may be electrically connected directly or indirectly to at least one second button 210 (hereinafter referred to as first control button) in the distance measurement module 20. Displayed content of the display module 40 changes when the second control button is pressed.

In some implementations, triggering any first button 310 causes the display module 40 to display function-specific information corresponding to the detection module 30 (e.g., material and position of hidden objects detected within a wall); triggering any second button 210 causes display of function-specific information for the distance measurement module 20 (e.g., distance from a target wall to the wall detection instrument 1). Additionally, displayed information undergoes 180-degree reversal when display content switches between functions of the detection module 30 and distance measurement module 20. This orientation inversion facilitates viewing during operation of either module.

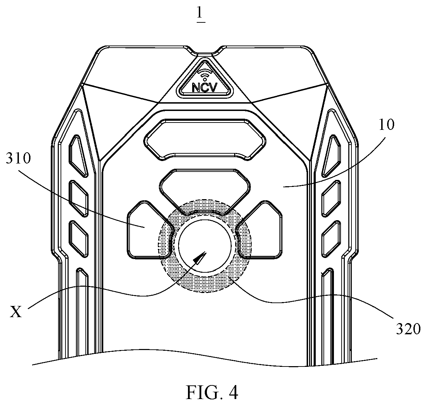

Referring to FIG. 4, the detection module 30 further includes a detection coil 320 disposed inside the housing 10. The detection coil 320 surrounds the marking hole X and acquires information about hidden objects. For example, the detection coil 320 emits electromagnetic waves that reflect at boundaries between different media (e.g., wall/air or wall/metal). Upon receiving reflected waves, the detection coil 320 transmits them to the processor of the wall detection instrument 1. By analyzing time delay and intensity of reflected waves, the processor determines position and depth of hidden objects (e.g., cavities or metal within walls). As another example, electromagnetic waves emitted from the detection coil 320 reflect at the pipe-wall interface when the detection coil 320 scans a plastic water pipe inside a wall. The processor of the wall detection instrument 1 calculates the pipe's depth based on reflected wave delay times and displays it on the display module 40.

It is to be understood that an orthographic projection of the detection coil 320 onto the solid medium precisely corresponds to hidden objects within the medium since the detection coil 320 acquires information about hidden objects. In the present embodiment, the detection coil 320 surrounds the marking hole X. This configuration ensures marks made through the marking hole X are relatively accurate.

In some implementations, a cross section of the marking hole X is circular, meaning the marking hole X is a circular hole. A circular hole facilitates arrangement of the first buttons 310 and enables smooth marking operations by the user. It should be noted that, viewed along the axial direction of the marking hole X: in one implementation, the marking hole X may be a cylindrical hole, meaning a diameter of the marking hole X is equal everywhere; in another implementation, the marking hole X may be a tapered hole, meaning the diameter of the marking hole X progressively decreases or increases along the axial direction.

In other implementations, a cross-sectional shape of the marking hole X may be elliptical, triangular, square, rectangular, pentagonal, rhombic, cruciform, pentagram-shaped, etc. Specific shapes may be configured according to requirements and are not exhaustively detailed herein.

In some implementations, the marking hole X is a circular hole, and the diameter of the marking hole X ranges from 5 mm to 15 mm. Specific diameters include such as 5 mm, 6 mm, 6.8 mm, 7 mm, 8 mm, 8.8 mm, 9 mm, 9.5 mm, 10 mm, 10.3 mm, 11 mm, 11.6 mm, 12 mm, 13 mm, 13.6 mm, 14 mm, and 15 mm. Limiting the diameter of the marking hole X to 5 mm to 15 mm provides moderate sizing that accommodates passage of most marking pens, thus offering broad applicability while preventing the marking hole X from occupying excessive space that would compromise arrangement of the detection module 30.

In some implementations, chamfers may be formed at axially opposite ends of the marking hole X. These chamfers may be rounded chamfers or straight chamfers. It is to be understood that forming chamfers at both ends of the marking hole X prevents sharp edges from injuring users and additionally guides insertion of marking pens into the marking hole X.

Referring to FIG. 2, the housing 10 includes a first housing 110, a second housing 120, and a columnar structure 130. The first housing 110 and the second housing 120 together form an accommodation space, that is, the first housing 110 and the second housing 120 are mutually covered, thereby enclosing the accommodation space. The accommodation space is configured to accommodate the distance measurement module 20 and the detection module 30. The columnar structure 130 is disposed in the accommodation space, and opposite two ends of the columnar structure 130 are respectively connected to the first housing 110 and the second housing 120. The columnar structure 130 is provided with a through hole, the through hole constituting the marking hole X. The aforementioned detection coil 320 is disposed in the accommodation space and arranged around the columnar structure 130.

The first housing 110 may be an integral structure or assembled from multiple components. A material of the first housing 110 may be plastic, rubber, etc., and the material preferably is one that does not interfere or almost does not interfere with measurement functions of the distance measurement module 20 and the detection module 30. Regarding the second housing 120, refer to the description of the first housing 110, and details are not repeated herein.

The first housing 110 and the second housing 120 may be detachably connected, for example, by threaded connection, snap connection, plug-in connection, etc. Employing detachable connection facilitates later disassembly for maintenance. The first housing 110 and the second housing 120 may also be non-detachably connected, for example, by adhesive bonding, heat fusion connection, etc. Employing non-detachable connection helps prevent separation of the first housing 110 and the second housing 120 due to dropping of the wall detection instrument 1.

The columnar structure 130 may be a component independent of the first housing 110 and the second housing 120, or a part of the first housing 110, or a part of the second housing 120. In some embodiments, the columnar structure 130 includes a first hollow column 131 and a second hollow column 132. The first hollow column 131 is provided with an internally hollow structure and is connected to the first housing 110, while the second hollow column 132 is provided with an internally hollow structure and is connected to the second housing 120. The first hollow column 131 and the second hollow column 132 are detachably plugged together to collectively form the marking hole X. In the present embodiment, splitting the columnar structure 130 into the first hollow column 131 and the second hollow column 132 ensures neither hollow column has an excessively long axial dimension. This configuration facilitates installation of other components or devices, such as a circuit board.

## Claims

1. A wall detection instrument (1), comprising:
a housing (10), the housing (10) being provided with a marking hole (X), the marking hole (X) penetrating through opposite two sides of the housing (10);
a distance measurement module (20), the distance measurement module (20) being installed in the housing (10), the distance measurement module (20) being configured to measure a distance from a target position to the wall detection instrument (1); and
a detection module (30), the detection module (30) being mounted in the housing (10) and adjacent to the marking hole (X), the detection module (30) being configured to detect a hidden object in a solid medium.

2. The wall detection instrument (1) according to claim 1, wherein the housing (10) is provided with a first end portion (D1) and a second end portion (D2), the first end portion (D1) and the second end portion (D2) are opposite two ends in a length direction of the housing (10), the distance measurement module (20) is disposed at the first end portion (D1), and the detection module (30) is disposed at the second end portion (D2).

3. The wall detection instrument (1) according to claim 1, wherein the housing (10) is provided with a first end portion (D1) and a second end portion (D2), the first end portion (D1) and the second end portion (D2) are opposite two ends in a length direction of the housing (10), the wall detection instrument (1) further comprises a non-contact voltage, NCV, module (50), and the NCV module (50) is disposed at the second end portion (D2).

4. The wall detection instrument (1) according to claim 1, wherein the housing (10) is provided with a first side (C1) and a second side (C2) that are opposite to each other, the marking hole (X) is extended from the first side (C1) through to the second side (C2), the detection module (30) comprises a first button (310), and the first button (310) is exposed on the first side (C1); and
the wall detection instrument (1) further comprises a display module (40), wherein the display module (40) is disposed between the detection module (30) and the distance measurement module (20), and a display area of the display module (40) is visible from the first side (C1).

5. The wall detection instrument (1) according to claim 4, wherein an amount of the first buttons (310) is plural, and at least two of the first buttons (310) are arranged around the marking hole (X).

6. The wall detection instrument (1) according to claim 4, wherein the distance measurement module (20) includes a second button (210), and the second button (210) is exposed on the first side (C1).

7. The wall detection instrument (1) according to claim 1, wherein the detection module (30) further includes a detection coil (320) disposed in the housing (10), the detection coil (320) is arranged around the marking hole (X), and the detection coil (320) is configured to acquire information of the hidden object.

8. The wall detection instrument (1) according to claim 1, wherein a cross section of the marking hole (X) is circular.

9. The wall detection instrument (1) according to claim 1, wherein the wall detection instrument (1) further comprises a marking module (60) disposed in the housing (10), the housing (10) is provided with a light exit port (Y), and the marking module (60) is configured to emit a laser line through the light exit port (Y) to outside of the housing (10), so that a preset mark appears at an irradiated position.

10. The wall detection instrument (1) according to any one of claims 1-9, wherein the housing (10) comprises a first housing (110), a second housing (120), and a columnar structure (130), the first housing (110) and the second housing (120) together form an accommodation space, the accommodation space is configured to accommodate the distance measurement module (20) and the detection module (30), opposite two ends of the columnar structure (130) are respectively connected to the first housing (110) and the second housing (120), the columnar structure (130) is provided with a through hole, and the through hole constitutes the marking hole (X).
